Europäisches Patentamt

European Patent Office

Office européen des brevets

(11) Publication number: **0 472 945 A2**

# EUROPEAN PATENT APPLICATION

(21) Application number: **91112949.2**

(22) Date of filing: **01.08.91**

(51) Int. Cl.5: **H01L 27/118, H01L 27/06**

(30) Priority: **01.08.90 JP 204539/90**

(43) Date of publication of application:
**04.03.92 Bulletin 92/10**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Sugimoto, Yasuhiro, c/o Intellectual**
**Pty. Division**

Kabushiki Kaisha Toshiba, 1-1 Shibaura
1-chome
Minato-ku, Tokyo 105(JP)
Inventor: **Hara, Hiroyuki, c/o Intellectual Pty.**
**Division**
Kabushiki Kaisha Toshiba, 1-1 Shibaura
1-chome
Minato-ku, Tokyo 105(JP)

(74) Representative: **Lehn, Werner, Dipl.-Ing. et al**
**Hoffmann, Eitle & Partner Patentanwälte**
**Arabellastrasse 4 Postfach 81 04 20**
**W-8000 München 81(DE)**

(54) **Semiconductor integrated circuit.**

(57) A Bi-CMOS gate circuit comprises a logic gate (41) including a MOS transistor and a driver (42) including a pull-up bipolar transistor (Q1) for outputting a high voltage and a pull-down bipolar transistor (Q2'') for outputting a low voltage. The pull-down bipolar transistor has a selectively ion-implanted collector structure in which part of a collector region contacting a base region has a high impurity concentration. The pull-up bipolar transistor (Q1) may have a selectively ion-implanted collector structure in which a collector region has a high impurity concentration region formed directly under an emitter region.

F I G. 3

The present invention relates to an improvement of a semiconductor integrated circuit comprising a MOS transistor and a bipolar transistor such as a Bi-CMOS gate circuit and a Bi-NMOS gate circuit.

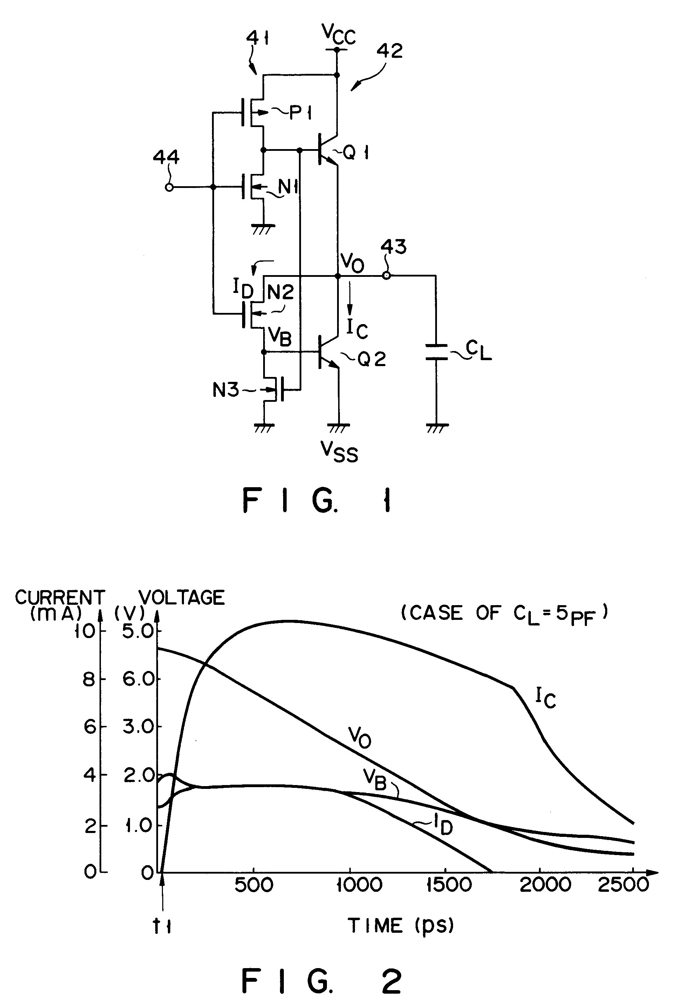

Fig. 1 shows a conventional Bi-CMOS gate circuit constituting a Bi-CMOS gate array. The feature of the Bi-CMOS gate circuit lies in high input impedance, high load driving performance, and low power consumption. The arrangement of the Bi-CMOS gate circuit will be described.

As shown in Fig. 1, the Bi-CMOS gate circuit comprises a logic gate 41 having a CMOS structure and a driver 42 having bipolar transistors which are pull-up and pull-down MPN transistors Q1 and Q2. The MPN transistor Q1 is connected between a power supply Vcc and an output terminal 43, and the NPN transistor Q2 is connected between the output terminal 43 and ground Vss. The logic gate 41 comprises a P-channel MOS transistor P1 and N-channel MOS transistors N1, N2 and N3. The P-channel MOS transistor P1 is connected between the power supply Vcc and the base of the NPN transistor Q1 to supply a current to the base of the NPN transistor Q1. The N-channel MOS transistor N1 is connected between the base of the NPN transistor Q1 and the ground Vss to discharge the base of the NPN transistor Q1. The N-channel MOS transistor N2 is connected between the output terminal 43 and the base of the NPN transistor Q2 to supply a current to the base of the NPN transistor Q2. The M-channel MOS transistor N3 is connected between the base of the NPN transistor Q2 and the ground Vss to discharge the base of the NPN transistor Q2. The gates of the P-channel MOS transistor P1 and the N-channel MOS transistors N1 and N2 are connected to an input terminal 44. The gate of the N-channel MOS transistor N3 is connected to the base of the NPN transistor Q1. A capacitor having a load capacity $C_L$ is connected to the output terminal 43.

An operation of the Bi-CMOS gate circuit will be described.

When a low-level potential is applied to the input terminal 44, the N-channel MOS transistors N1 and N2 are turned off. Since, in this case, the P-channel MOS transistor P1 is turned on, the NPN transistor Q1 and N-channel MOS transistor N3 are turned on. The NPN transistor Q2 is thus turned off and a high-level potential is applied to the output terminal 43.

When a high-level potential is applied to the input terminal 44, the P-channel MOS transistor P1 is turned off and the N-channel MOS transistor N1 is turned on. The NPN transistor Q1 and N-channel MOS transistor N3 are therefore tuned off. Further, the N-channel MOS transistor N2 is turned on and thus the NPN transistor Q2 are turned on. A low-level potential is thus applied to the output terminal 43.

It is known that a large amount of current flows in the above Bi-CMOS gate circuit when an output potential changes. Fig. 2 shows a relationship between time and output voltage $V_O$, collector current $I_C$ of NPN transistor Q2, base potential $V_B$ of NPN transistor Q2, and drain current $I_D$ of N-channel MOS transistor N2 when the potential of the input terminal 44 of the Bi-CMOS gate circuit changes from a low level to a high level at time $t_1$. The relationship shown in Fig. 2 is obtained when the load capacity $C_L$ is 5 pF.

As is apparent from Fig. 2, when the load capacity $C_L$ of the capacitor is 5 pF, the collector current $I_C$ of the NPN transistor Q2 is about 10 mA at the most, so that it continues to flow for 2 ns or more. Since the width of the base of NPN transistor Q2 seemingly extends in a region through which a large amount of collector current $I_C$ flows, if the collector current $I_C$ exceeds 2 mA, cut-off frequency $F_T$ and current amplification factor hfe of the NPN transistor Q2 greatly decrease (Kirk effect). The Bi-CMOS gate circuit cannot therefore be operated at high speed.

To operate the Bi-CMOS gate circuit at high speed, it is necessary that the cut-off frequency $F_T$ and current amplification factor hfe should not be reduced in the region of the NPN transistor Q2, through which a large amount of collector current $I_C$ flows.

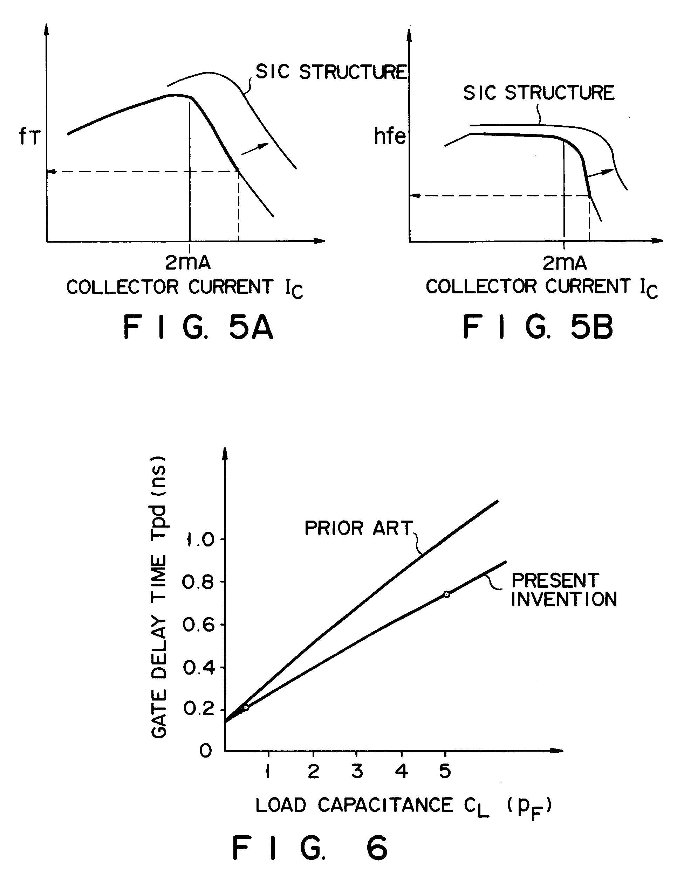

However, in a conventional bipolar transistor whose emitter is about $2 \times 10 \ \mu m$ in size, the cut-off frequency $f_T$ and current amplification factor hfe of the bipolar transistor greatly decrease when the collector current $I_C$ exceeds 2 mA, as indicated by thick lines in Figs. 5A and 5B.

If the emitter of bipolar transistor Q2 increases in size, a capacity between the base and emitter of transistor Q2 and a capacity between the base and collector thereof increase. This is unfavorable to a high-speed operation of the Bi-CMOS gate circuit.

The present invention has been made to resolve the above problem of the prior art and its object is to provide a semiconductor integrated circuit comprising a Bi-CMOS gate circuit in which the cut-off frequency and current amplification factor of a bipolar transistor of a driver are prevented from decreasing in a region of the bipolar transistor, through which a large amount of collector current flows, thereby performing a high-speed operation of the Bi-CMOS gate circuit.

According to the present invention, there is provided a semiconductor integrated circuit comprising a logic gate including a MOS transistor, and a driver including a pull-up bipolar transistor for outputting a high voltage and a pull-down bipolar transistor for outputting a low voltage. At least one of the pull-up and pull-down bipolar transistors has a selectively ionimplanted collector structure in which a collector region has a high impurity concentration region formed directly under an emitter region.

This invention can be more fully understood from the following detailed description when taken in conjunction with the accompanying drawings, in which:

Fig. 1 is a circuit diagram showing a conventional Bi-CMOS gate circuit;

Fig. 2 is a graph showing relationships between time and voltages and currents of components of the Bi-CMOS gate circuit shown in Fig. 1;

Fig. 3 is a circuit diagram showing a Bi-CMOS gate circuit according to an embodiment of the present invention;

Fig. 4 is a cross-sectional view showing a bipolar transistor having a selectively ion-implanted collector (SIC) structure;

Fig. 5A is a graph showing a relationship between collector current $I_C$ and cut-off frequency $f_T$ of the bipolar transistor shown in Fig. 4;

Fig. 5B is a graph showing a relationship between collector current $I_C$ and current amplification factor hfe of the bipolar transistor shown in Fig. 4;

Fig. 6 is a graph showing a relationship between load capacity $C_L$ and gate delay time Tpd of the Bi-CMOS gate circuit shown in Fig. 3; and

Fig. 7 is a circuit diagram showing a Bi-CMOS gate circuit according to another embodiment of the present invention.

An embodiment of the present invention will be described with reference to the accompanying drawings.

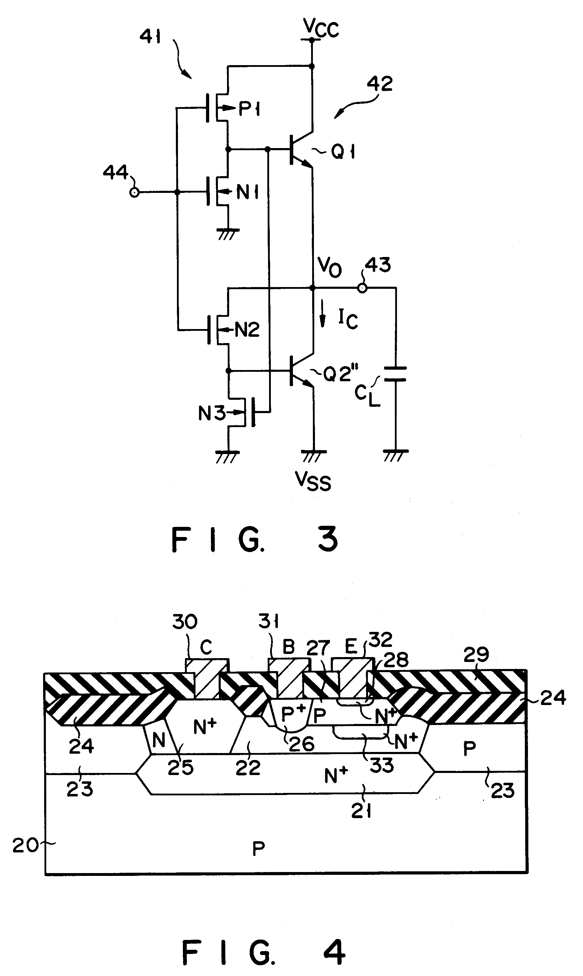

Fig. 3 shows a basic arrangement of a Bi-CMOS gate circuit constituting a Bi-CMOS gate array. In Fig. 3, the same components as those of the conventional Bi-CMOS gate circuit shown in Fig. 1 are denoted by the same reference numerals. In the Bi-CMOS gate circuit according to the present invention, a bipolar transistor Q2" having a selectively ion-implanted collector (SIC) structure is used as a bipolar transistor of a driver, for example, a pull-down transistor.

Fig. 4 shows a structure of the bipolar transistor Q2". In Fig. 4, reference numeral 20 indicates a P-type semiconductor substrate; 21, an $N^+$-type buried layer; 22, an N well serving as a collector region; 23, a P well for dividing the N well into a plurality of regions; 24, an element isolating insulation film; 25, an $N^+$-type low-resistance region formed from the surface of the N well to the $N^+$-type buried layer; 26, a $P^+$-type external base region; 27, a P-type internal base region; 28, an $N^+$-type emitter region; 29, an insulation film; 30, a contact electrode contacting the collector region;

31, a base electrode contacting the external base region; 32, an emitter electrode contacting the emitter region; and 33, an $N^+$-type SIC region whose impurity concentration is higher than that of the N well.

The feature of the bipolar transistor Q2" having the above structure lies in that the $N^+$-type SIC region 33 is formed in the collector region 22, and it is formed directly under the emitter region 28. The SIC region can be formed in a correct position if an acceleration voltage of ions is controlled by, e.g., ion implantation. In other words, the SIC region can be formed if the number of masks is larger by one than that of masks in the conventional circuit or a mask is used to form both the P well and the SIC region. The process of manufacturing the bipolar transistor is not therefore complicated.

The above bipolar transistor having the SIC structure can prevent the base region from seemingly expanding in a region through which a large amount of collector current (Kirk effect) flows. As indicated by thin lines in Figs. 5A and 5B, even though the collector current $I_C$ exceeds 2 mA, neither cut-off frequency $F_T$ nor current amplification factor hfe decreases.

In the Bi-CMOS gate circuit according to the above embodiment, when the load capacity $C_L$ is 5 pF, the maximum value of collector current $I_C$ of the pull-down transistor Q2 is 10 mA or more. The charges of the load capacity $C_L$ can thus be extracted for a shorter time than in the conventional circuit. In other words, a time required that the output voltage $V_O$ decreases is shortened and accordingly the Bi-CMOS gate circuit can be operated at high speed.

A method of manufacturing the bipolar transistor Q2" having the SIC structure is the same as that of manufacturing a commonly-used bipolar transistor, except for addition of one mask. In the former method, a mask is used for forming the emitter region, and it is also used for forming the SIC region in another process.

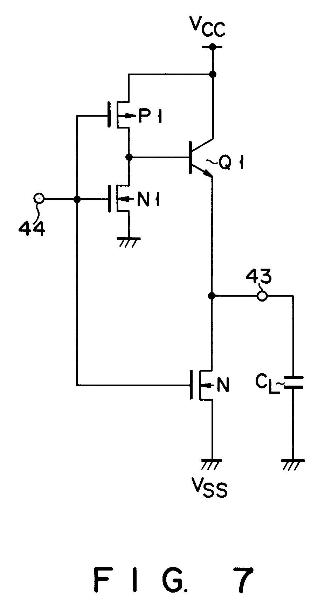

Fig. 6 shows a relationship between load capacity $C_L$ and gate delay time Tpd of the Bi-CMOS gate circuit. Using a bipolar transistor having an SIC structure, when the load capacity L is 5 pF, the gate delay time is shorter about 25 percent than that of the conventional Bi-CMOS gate circuit. It is thus apparent from Fig. 6 that the Bi-CMOS gate circuit of the present invention becomes effective as the load capacity $C_L$ is enlarged.

In the above embodiment, the bipolar transistor Q2" having an SIC structure is used for the pull-down bipolar transistor of the driver, but it can be used for the pull-up bipolar transistor. As shown in Fig. 7, in a Bi-NMOS gate circuit having an NMOS transistor as a pull-down transistor, it is effective in using a bipolar transistor having an SIC structure as a pull-up transistor.

The present invention is not limited to the Bi-CMOS gate array but can be applied to a Bi-CMOS integrated circuit comprising both a bipolar transistor and a MOS transistor.

**Claims**

1. A Bi-CMOS gate circuit comprising:

   a logic gate (P1, N1 to N3) including a MOS transistor;

   a pull-up bipolar transistor (Q1) for outputting a high voltage; and

   a pull-down bipolar transistor (Q2'') for outputting a low potential,

   said pull-down bipolar transistor having a selectively ion-implanted collector structure in which a collector region has a high impurity concentration region formed directly under an emitter region.

2. The Bi-CMOS gate circuit according to claim 1, characterized in that said pull-up bipolar transistor has a selectively ion-implanted collector structure in which a collector region has a high impurity concentration region formed directly under an emitter region.

3. A Bi-CMOS gate circuit comprising:

   a logic gate (P1, N1 to N3) including a MOS transistor;

   a pull-up bipolar transistor for (Q1) outputting a high voltage; and

   a pull-down bipolar transistor for (Q2'') outputting a low voltage,

   at least one of said pull-up and pull-down bipolar transistors having a selectively ion-implanted collector structure in which a collector region has a high impurity concentration region formed directly under an emitter region.

4. A Bi-NMOS gate circuit comprising:

   a logic gate (P1, N1) including a MOS transistor;

   a pull-up bipolar transistor for (Q1) outputting a high voltage; and

   an N-channel MOS transistor (N) for outputting a low potential,

   said pull-up bipolar transistor having a selectively ion-implanted collector structure in which a collector region has a high impurity concentration region formed directly under an emitter region.

F I G. 1

F I G. 2

F I G. 3

F I G. 4

F I G. 5A

F I G. 5B

F I G. 6

7

# F I G. 7